# EUROPÄISCHE PATENTSCHRIFT

(11) **EP 1 088 396 B1**
(45) Veröffentlichungstag und Bekanntmachung des Hinweises auf die Patenterteilung: **27.03.2002**
(21) Anmeldenummer: 99938145.2
(22) Anmeldetag: 08.06.1999
(51) Int. Cl.: H03M 1/82, H03K 9/08

(54) **EINRICHTUNG ZUR SCHNELLEN D/A-WANDLUNG VON PWM-SIGNALEN**
DEVICE FOR QUICK D/A CONVERSION OF PWM SIGNALS
DISPOSITIF POUR EFFECTUER UNE CONVERSION N/A RAPIDE DE SIGNAUX MID

(30) Priorität: 25.06.1998 DE 19828399
(43) Veröffentlichungstag der Anmeldung: 04.04.2001
(73) Patentinhaber: SIEMENS AKTIENGESELLSCHAFT, 80333 München (DE)
(72) Erfinder: BOLZ, Stephan, D-93102 Pfatter (DE)
(86) Internationale Anmeldenummer: DE9901678
(87) Internationale Veröffentlichungsnummer: WO9967885

(56) Entgegenhaltungen:
- EP-A- 0 417 578
- US-A- 3 624 529
- PATENT ABSTRACTS OF JAPAN vol. 016, no. 055 (E-1165), 12. Februar 1992 (1992-02-12) -& JP 03 254214 A (FUJI ELECTRIC CO LTD), 13. November 1991 (1991-11-13)
- PATENT ABSTRACTS OF JAPAN vol. 006, no. 119 (E-116), 3. Juli 1982 (1982-07-03) -& JP 57 048826 A (JAPAN ELECTRONIC CONTROL SYST CO LTD), 20. März 1982 (1982-03-20)

## Beschreibung

Die Erfindung betrifft eine Einrichtung zur schnellen Digital-Analog-(D/A-)Wandlung von Pulsweiten-modulierten (PWM-) Signalen, insbesondere von digitalisierten und in PWM-Signale gewandelten analogen Ausgangssignalen einer Lambdasonde in einem Kraftfahrzeug, nach den Merkmalen des Oberbegriffs von Anspruch 1.

Moderne Mikrocontroller werden aus Kostengründen zunehmend für Digital-Signal-Prozessor-Anwendungen in Regelsystemen eingesetzt. Dazu wird die analoge Meßgröße mittels eines Analog/Digital-(A/D-)Wandlers digitalisiert, im Mikrocontroller durch ein Programm modifiziert (Filterung, Vergleich mit Sollgrößen, PID-Regler u.s.w.) und anschließend mittels eines D/A-Wandlers wieder in ein analoges Signal umgewandelt. Mikrocontroller beinhalten zwar üblicherweise A/D-Wandler zur Digitalisierung analoger Meßgrößen, ein D/A-Wandler ist in der Regel jedoch nicht integriert.

Eine Möglichkeit zur D/A-Wandlung ist die Verwendung eines externen D/A-Wandlers; das ist die technisch optimale Lösung, jedoch auch die kostenintensivste! Bei einem seriellen D/A-Wandler mit einer Taktfrequenz von beispielsweise 500kHz bei 10Bit Genauigkeit ergibt sich eine Wandlungsdauer von theoretisch 2ms, praktisch jedoch ca. 3ms. Diese Wandlungsdauer geht als Verzögerungszeit in die Phasenverschiebung der Regelschleife ein.

Eine weitere Möglichkeit ist die Wandlung des Digitalsignals im Mikroprozessor in ein Signal mit fester Frequenz sowie mit einem dem Digitalwert proportionalen Tastverhältnis mit anschließender externer Tiefpaß-Filterung zur Beseitigung der Wechselspannungsanteile. Diese Lösung ist wesentlich preiswerter als ein D/A-Wandler und wird des öfteren für weniger anspruchsvolle Anwendungen benutzt. Für den Einsatz in einem Regelsystem hat diese Lösung jedoch den Nachteil, daß der zur Filterung notwendige Tiefpaß die Phase des Signals sehr verzögert (Gruppenlaufzeit). Liegt diese Verzögerung innerhalb der Regelschleife, so trägt sie zur gesamten Phasenverzögerung der Regelschleife bei.

Beispielsweise beträgt bei einem Tiefpaß dritter Ordnung mit einer Frequenz von 100Hz die Dämpfung -60dB. D.h., die Amplitude eines PWM-Signals mit 5V wird auf 5mV abgeschwächt. Die Gruppenlaufzeit beträgt dabei etwa 50ms. Bei einer Erhöhung der PWM-Frequenz auf 250Hz und entsprechender Anpassung des Tiefpasses würde die Gruppenlaufzeit auf 20ms reduziert werden, was etwa der technischen Grenze dieses Systems entspricht.

Aus Patent Abstracts of Japan vol. 016, no. 055 (E-1165), 12. Februar 1992 (1992-02-12)-&JP 03 254214 A (Fuji Electric Co Ltd), 13. November 1991 (1991-11-13) ist eine Einrichtung zur D/A-Wandlung von PWM-Signalen bekannt, welche ein Flipflop, zwei Integratoren und einen Entkopplungsverstärker aufweist, wobei der eine Integrator das PWM-Signal während einer High-Phase integriert und wenigstens während der darauffolgenden Low-Phase die D/A-gewandelte Spannung am Ausgang bereitstellt. In dieser Low-Phase wird der andere Kondensator inzwischen entladen.

Aus Patent Abstracts of Japan vol. 006, no. 119 (E-116), 3. Juli 1982(1982-07-03)-&JP 57 048826 A (Japan Electronic Control Syst Co Ltd), 20. Mäez 1982 (1982-03-20) ist eine Einrichtung zur D/A-Wandlung von PWM-Signalen mit einem Monoflop, einem Integrator, einem Speicherkondensator und einem Entkopplungsverstärker bekannt, wobei das PWM-Signal während seiner Low-Phase integriert wird.

Aus DE 32 37 386 C2 ist ein Digital-Analog-Wandler vom Zählertyp für die Verarbeitung eines Puls-Code-modulierten Stereo-Tonsignals bekannt, bei welchem die abwechselnd erscheinenden digitalen Datenwörter des linken und rechten Tonkanals seriell in entsprechende analoge Ströme gewandelt werden, welche parallel in je einem Integrator in Spannungssignale umgesetzt werden, die anschließend über je ein Tiefpaßfilter laufen.

Es ist Aufgabe der Erfindung, eine preiswerte Einrichtung zur schnellen und genauen D/A-Wandlung von PWM-Signalen zu schaffen, ohne einen kostenintensiven D/A-Wandler zu verwenden, jedoch mit einer einem D/A-Wandler vergleichbaren Phasenverzögerung.

Diese Aufgabe wird erfindungsgemäß durch eine Einrichtung mit den Merkmalen des Anspruchs 1 gelöst. Vorteilhafte Ausgestaltungen der Erfindung sind den Unteransprüchen zu entnehmen.

Die erfindungsgemäße Einrichtung weist eine einem mit 500kHz Taktfrequenz betriebenen digitalen lOBit-D/A-Wandler vergleichbare Phasenverzögerung auf, nämlich etwa 10ms bei 100Hz und etwa 4ms bei 250Hz Taktfrequenz. Sie ist wesentlich kostengünstiger als ein integrierter D/A-Wandler und weist um die Mittellage eine hohe Grundgenauigkeit auf, was bei der Erzeugung symmetrischer Ausgangsspannungen besonders wichtig ist.

Ein Ausführungsbeispiel der Erfindung wird nachstehend anhand einer schematischen Zeichnung näher erläutert.

In der Zeichnung zeigen:
- Figur 1: die Schaltung einer erfindungsgemäßen Einrichtung, und
- Figur 2: verschiedene Signalverläufe dazu.

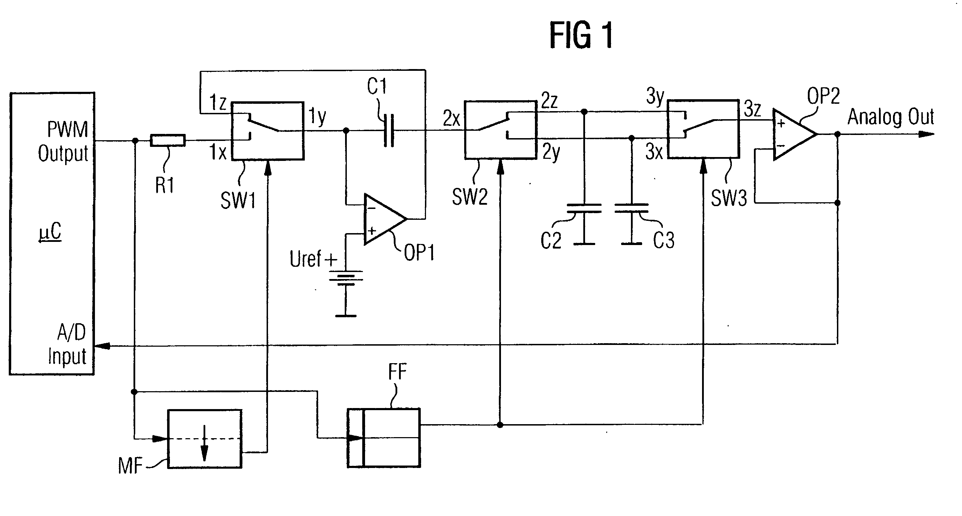

Figur 1 zeigt einen Mikrocontroller µC, welchem das analoge Ausgangssignal eines Sensors S, beispielsweise einer im Abgastrakt einer Brennkraftmaschine angeordneten Lambdasonde, zugeführt wird. Im Mikrocontroller µC wird es in ein digitales Signal gewandelt und verarbeitet (Filterung, Vergleich mit Sollgrößen, PID-Regler u.s.w.). Das verarbeitete Digitalsignal erscheint, zu einem dem Digitalsignal proportionalen PWM-Signal mit konstanter Frequenz gewandelt, am Ausgang A des Mikrocontrollers µC.

Das PWM-Signal wird einem für eine Dauer von beispielsweise 30 - 50 µs getriggerten Monoflop MF und parallel dazu einem als Frequenzteiler wirkenden Flipflop FF zugeführt. Monoflop MF und Flipflop FF können eingespart werden, wenn deren Ausgangssignale im Mikrocontroller erzeugt werden.

Das PWM-Signal wird über einen Widerstand R1 auch einem ersten Anschluß 1x eines vom Ausgangssignal des Monoflops gesteuerten ersten Umschalters SW1 zugeführt.

Ein zweiter Anschluß 1y des ersten Umschalters SW1 ist mit dem invertierenden Eingang eines ersten Operationsverstärkers OP1 verbunden. Zwischen diesen invertierenden Eingang und den Ausgang des ersten Operationsverstärkers OP1 ist ein erster Kondensator C1 geschaltet. Der Ausgang des ersten Operationsverstärkers OP1 ist mit einem dritten Anschluß 1z des ersten Umschalters SW1 verbunden. Der nichtinvertierende Eingang des ersten Operationsverstärkers OP1 ist mit einer Referenzspannung Uref beaufschlagt.

Der erste Operationsverstärker OP1 bildet zusammen mit dem ersten Kondensator C1 und dem Widerstand R1 einen invertierenden Integrator, wenn der erste Anschluß 1x des ersten Umschalters SW1 mit dem zweiten Anschluß 1y verbunden ist. Der Integrator integriert das PWM-Signal und wandelt es in ein bezüglich einer vorgegebenen Referenzspannung symmetrisches Signal. Wenn der dritte Anschluß 1z des ersten Umschalters SW1 mit dem zweiten Anschluß 1y verbunden ist, wird der erste Kondensator C1 kurzgeschlossen und entladen. Die Ausgangsspannung des ersten Operationsverstärkers OP1 geht in diesem Fall auf die Referenzspannung Uref.

Der Ausgang des Operationsverstärkers OP1 (des Integrators) ist mit einem ersten Anschluß 2x eines zweiten Umschalters SW2 verbunden. Außerdem ist ein dritter Umschalter SW3 vorgesehen, wobei der zweite Anschluß 2y des zweiten Umschalters SW2 mit dem ersten Anschluß 3x des dritten Umschalters SW3 verbunden ist und wobei der dritte Anschluß 2z des zweiten Umschalters SW2 mit dem zweiten Anschluß 3y des dritten Umschalters SW3 verbunden ist.

Vom Minuspol einer Betriebsspannung, die beispielsweise 5V beträgt, führt ein zweiter Kondensator C2 zum Anschluß 2z und ein dritter Kondensator C3 zum Anschluß 2y. Der dritte Anschluß 3z des dritten Umschalters SW3 ist mit dem nichtinvertierenden Eingang eines als Bufferverstärker geschalteten zweiten Operationsverstärkers OP2 verbunden, an dessen Ausgang das in einen Analogwert gewandelte PWM-Signal erscheint. Dieser Ausgang ist mit seinem invertierenden Eingang verbunden.

In einer vorteilhaften Weiterbildung der Erfindung ist der Ausgang des zweiten Operationsverstärkers OP2 mit dem (oder einem) A/D-Wandler-Eingang des Mikrocontrollers µC verbunden. Die Funktion dieser Maßnahme wird weiter unten beschrieben.

Der zweite und der dritte Umschalter SW2 und SW3 werden synchron vom Ausgangssignal des Flipflops FF umgeschaltet, wie später näher beschrieben wird.

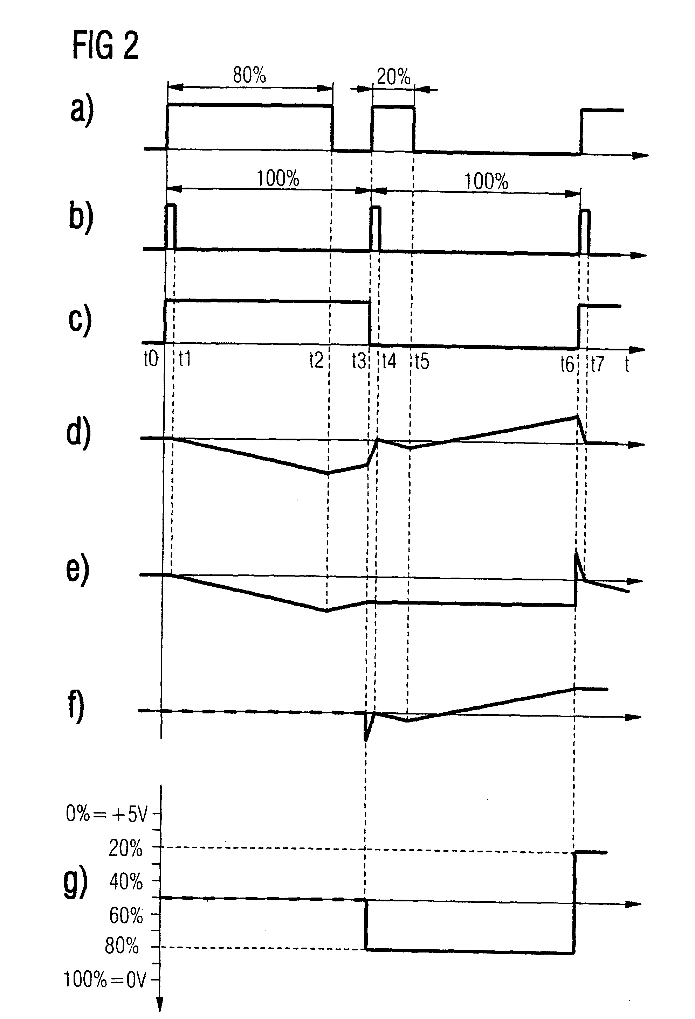

Figur 2 zeigt im Signalverlauf a zwei Perioden des am Ausgang A des Mikrocontrollers µC erscheinenden PWM-Signals, wobei in der ersten Periode ein Tastverhältnis von 80% und in der zweiten Periode eines von 20% angenommen ist.

Auf der Abszisse aller Signalverläufe in Figur 2 ist die Zeit t aufgetragen; Die Nullpunkte der Ordinaten der Signale a, b und c seien einem Potential von 0V = "L" zugeordnet, während die Amplituden dieser Signale ein Potential von +5V = "H" aufweisen sollen. Die Nullpunkte der Ordinaten der Signale d bis g seien einem Potential von +2,5V zugeordnet, während die Amplituden dieser Signale ein Potential von +2,5V ± 2,5V (also +5V und 0V) aufweisen können.

Das Verfahren zum Betreiben dieser Einrichtung wird nachstehend anhand der in Figur 2 dargestellten Signalverläufe a bis g näher erläutert.

Über die "Einschaltstellung" des ersten Umschalters SW1 (Ausgangssignal mf des Monoflops auf +5V = H; Anschlüsse 1x und 1y miteinander verbunden; to bis t2) wird das PWM-Signal (Figur 2a) dem invertierenden Integrator zugeführt.

Mit der ansteigenden Flanke des PWM-Signals (Figur 2a) wird der erste Kondensator C1 über den ersten Umschalter SW1 (Anschlüsse 1y und 1z miteinander verbunden) während einer vorgegebenen Standzeit des flankengetriggerten Monoflops MF von ca. 30-50µs (to bis t1) kurzgeschlossen und liegt dann auf dem Referenzpotential von +2,5V. Diese Entladezeit ist sehr klein, verglichen mit der PWM-Periode von 10ms (4ms). Zur Vermeidung eines Fehlers bei der A/D-Wandlung kann die High-Phase jedes PWM-Signals um diese 30-50µs verlängert werden.

Beginnend im Zeitpunkt t1 wird der erste Kondensator C1 über den ersten Umschalter SW1 (Anschlüsse 1x und 1y miteinander verbunden) mit einer Lade-/Entladegeschwindigkeit von 2,5V/Periode entladen, solange das PWM-Signal auf H-Pegel liegt (t1 bis t2 in Figur 2d). Bei angenommener Taktfrequenz von 100Hz und Tastverhältnis 80% entlädt sich der Kondensator auf eine Spannung von +2,5V - 0,8*2,5V = +0,5V, die er im Zeitpunkt t2 erreicht.

Anschließend liegt das PWM-Signal für den Rest von 20% der Periodendauer (t2 bis t3) auf L-Pegel; während dieser Zeit wird der erste Kondensator C1 von +0,5V um 0,2*2,5V = 0,5V auf +1V aufgeladen.

Während der zweiten Periode (t3 bis t6) wiederholt sich der Vorgang, beginnend mit dem Kurzschließen des ersten Kondensators C1 bei +2,5V (t3 bis t4; Figur 2b,d), anschließendem Entladen (20% Periodendauer) auf +2,5V - 0,2*2,5V = +2V (t4 bis t5) und Laden (80% Periodendauer) auf 2,0V + 0,8*2,5V = +4,0V (t5 bis t6).

Mit jeder ansteigenden Flanke des PWM-Signals (to,t3,t6 ...) wird das Flipflop FF umgeschaltet. Dessen Ausgangssignal ist in Figur 2c dargestellt. Dieses Ausgangssignal ff steuert die beiden Umschalter SW2 und SW3 so, daß beispielsweise in einer Periode (von to bis t3, wenn ff = H) der zweite Kondensator C2 mit dem Ausgang des ersten Operationsverstärkers OP1 verbunden ist, und der dritte Kondensator C3 mit dem nichtinvertierenden Eingang des zweiten Operationsverstärkers OP2 verbunden ist, und in der nächsten Periode (von t3 bis t6, wenn ff = L) der zweite Kondensator C2 mit dem nichtinvertierenden Eingang des zweiten Operationsverstärkers OP2 verbunden ist, und der dritte Kondensator C3 mit dem Ausgang des ersten Operationsverstärkers OP1 verbunden ist, u.s.w..

Das hat zur Folge, daß in der einen (ersten) Periode (t0 bis t3) der zweite Kondensator C2 exakt der Spannung des ersten Kondensators C1 folgt. Die Spannung, welche er im Umschaltzeitpunkt t3 aufweist, hält er für die nächste Periode (t3 bis t6) konstant; diese Spannung erscheint für die ganze Dauer der zweiten Periode am Ausgang des zweiten Operationsverstärkers OP2
(Figur 2e).

In der nächsten (zweiten) Periode (t3 bis t6) folgt der dritte Kondensator C3 exakt der Spannung des ersten Kondensators C1. Die Spannung, welche er im Umschaltzeitpunkt t6 aufweist, hält er für die folgende Periode (ab t6) konstant; diese Spannung erscheint für die ganze Dauer der dritten Periode am Ausgang des zweiten Operationsverstärkers OP2 (Figur 2f, 2g).

Durch die synchrone Umschaltung am Beginn jeder PWM-Periode erfolgt die Aufladung der Kondensatoren C2, C3 langsam mit der Geschwindigkeit des Integrators. Dadurch werden hohe Ladeströme vermieden. Entsprechend genau folgt die Spannung an diesen Kondensatoren der Integratorspannung. Für C2, C3 sind Kondensatoren mit großen Kapazitätswerten einsetzbar, was den Spannungsabfall in den Haltephasen verringert. Jeweils am Ende einer Integrationsphase (PWM-Periode) steht der aktuelle Spannungswert sofort zur Verfügung. Auf diese Weise wird das PWM-Signal in ein Analogsignal gewandelt (Spannungsskala auf der Ordinate von Figur 2g), wobei ein PWM-Tastverhältnis von 0% einer Spannung am Ausgang des zweiten Operationsverstärkers OP2 von +5V entspricht; 50% ≡ +2,5V, 100% ≡ 0V.

Die Phasenverzögerung (entspricht der Periodendauer) der beschriebenen Schaltung beträgt 10ms bei einer angenommenen Taktfrequenz von 100Hz, 4ms bei 250Hz. Damit liegt sie in der Größenordnung eines digitalen A/D-Wandlers (ca. 3ms) und ist (um den Faktor 5!) wesentlich kürzer als bei der eingangs beschriebenen Lösung mit einem Tiefpaß (50/20ms).

Die Genauigkeit des Ausgangssignals des Integrators hängt von folgenden Fehlerquellen ab:
- von der Zeitkonstante der Integrationsglieder R1, C1;
- von der Genauigkeit der Referenzspannung Uref;
- von den Offsetspannungen der Operationsverstärker OP1, OP2.

Diese Fehler liegen wesentlich über denen eines 10Bit-D/A-Wandlers. Durch die bereits erwähnte Rückführung des D/A-gewandelten Ausgangssignals des Operationsverstärkers OP2 zum A/D-Wandler des Mikrocontrollers µC kann der Wert des erzeugten Signals mit dem ursprünglichen digitalen Wert verglichen und zu einer Fehlerkorrektur benutzt werden.

Diese Fehlerkorrektur kann statisch erfolgen, indem beispielsweise PWM-Signale mit 0%, 50% und 100% Tastverhältnis erzeugt und integriert werden, wobei das tatsächliche Tastverhältnis oder die Frequenz so geregelt wird, daß die Soll/Ist-Differenz minimiert wird. Die so erhaltenen PWM-Werte bilden - mittels linearer Interpolation - die Berechnungsgrundlage für Zwischenwerte.

Dieses Verfahren arbeitet ohne weiteren Zeitverzug, bedarf aber zyklischer Wiederholungen, um Temperaturdriften auszugleichen.

Die Fehlerkorrektur kann mit einem fortlaufenden Soll/IstVergleich auch dynamisch erfolgen, indem das ermittelte Fehlersignal unmittelbar zur Korrektur des folgenden Signalwertes herangezogen wird. Dies erfordert einen Software-PID-Regler.

## Patentansprüche

1. Einrichtung zur schnellen Digital-Analog-(D/A-)-Wandlung von Puisweiten-modulierten (PWM-)Signalen, insbesondere von digitalisierten und in PWM-Signale gewandelten, analogen Ausgangssignalen einer Lambdasonde in einem Kraftfahrzeug, mit einem Integrator (Rl, C1, OP1), einem Umschalter (SW3), einem Bufferverstärker (OP2) und einem Frequenzteiler (FF),
**dadurch gekennzeichnet,**
**daß** der Integrator (OP1) als invertierender Integrator ausgebildet ist und einen ersten Operationsverstärker (OP1) aufweist, zwischen dessen invertierendem Eingang und dessen Ausgang ein erster Kondensator (C1) angeordnet ist, und dessen nichtinvertierendem Eingang eine vorgegebene Referenzspannung (Uref) zugeführt wird,
**daß** ein erster Umschalter (SW1) vorgesehen ist, welcher den invertierenden Eingang des Operationsverstärkers (OP1)
- über seinen ersten und zweiten Anschluß (1x, 1y) und einen Widerstand (R1) mit dem Eingang der Einrichtung verbindet, und
- über seinen zweiten und dritten Anschluß (1y, 1z) mit seinem Ausgang verbindet,
**daß** dem Integrator (OP1) ein zweiter Umschalter (SW2) nachgeschaltet ist, der den Integrator (OP1)
- über seinen ersten und dritten Anschluß (2x, 2z) mit einem zweiten Kondensator (C2) verbindet, und
- über seinen ersten und zweiten Anschluß (2x, 2y) mit einem dritten Kondensator (C3) verbindet,
**daß** der dritte Umschalter (SW3) den nichtinvertierenden Eingang des als Bufferverstärker geschalteten zweiten Operationsverstärkers (OP2)
- über seinen zweiten und dritten Anschluß (3y, 3z) mit dem zweiten Kondensator (C2) verbindet, und
- über seinen ersten und dritten Anschluß (3x, 3z) mit dem dritten Kondensator (C3) verbindet,
**daß** der Ausgang des zweiten Operationsverstärkers (OP2) der Ausgang der Einrichtung ist,
**daß** ein vom Eingangssignal der Einrichtung getriggertes Monoflop (MF) mit vorgegebener Standzeit vorgesehen ist, von dessen Ausgangssignal der erste Umschalter (SW1) geschaltet wird, und
**daß** vom Ausgangssignal des vom Eingangssignal der Einrichtung getriggerten Flipflops (FF) der zweite und der dritte Umschalter (S2, SW3) geschaltet werden.

2. Einrichtung nach Anspruch 1, **dadurch gekennzeichnet, daß** ein Mikrocontroller (µC) vorgesehen ist, in welchem eine A/D-Wandlung analoger Signale in digitale PWM-Signale mit konstanter Taktfrequenz erfolgt.

3. Verfahren zum Betreiben der Einrichtung nach Anspruch 1, **dadurch gekennzeichnet,**
**daß** mit jeder ansteigenden Flanke (to, t3, t6) des PWM-Signals das Monoflop (MF) für eine vorgegebene Standzeit (to-t1, t3-t4, t6-t7) getriggert wird und während dieser Standzeit den ersten Umschalter (SW1) aus seiner ersten Stellung (1x, ly), in welcher das PWM-Signal dem Integrator (OP1, R1, C1) zuführt wird, in seine zweite Stellung (1y, 1z) bringt, in welcher der erste Kondensator (C1) kurzgeschlossen wird,
**daß** das PWM-Signal im Integrator (OP1, R1, C1) zu einer auf eine vorgegebene Referenzspannung (Uref) bezogenen Integratorspannung integriert wird, und
**daß** mit jeder ansteigenden Flanke (to, t3, t6) des PWM-Signals das Flipflop (FF) getriggert wird, von dessen Ausgangssignalen der zweite und der dritte Umschalter (SW2, SW3) gleichzeitig umgeschaltet werden, wobei
- in einer Taktperiode der zweite Kondensator (C2) auf die Integratorspannung aufgeladen wird, während der dritte Kondensator (C3) über den zweiten Operationsverstärker (OP2) mit dem Ausgang der Einrichtung verbunden ist, an dem das Ausgangssignal der vorhergehenden Taktperiode abgreifbar ist, und
- in der folgenden Taktperiode der dritte Kondensator (C3) auf die Integratorspannung aufgeladen wird, während der zweite Kondensator (C2) über den zweiten Operationsverstärker (OP2) mit dem Ausgang der Einrichtung verbunden ist, an dem das Ausgangssignal der einen Taktperiode ab greifbar ist.

4. Verfahren nach Anspruch 3, **dadurch gekennzeichnet, daß** jede High-Phase des PWM-Signals um die Standzeit des Monoflops (MF) verlängert wird.

5. Verfahren nach Anspruch 3 oder 4, **dadurch gekennzeichnet, daß** das Ausgangssignal der Einrichtung zu bestimmten Zeiten oder in vorgegebenen Abständen dem Mikrocontroller (µC) zugeführt wird, der es in einen Digitalwert zurückwandelt und als Istwert mit dem Digitalwert des dem Tastverhältnis des zugeordneten PWM-Signals proportionalen Sollwert vergleicht, und
daß eine ermittelte Differenz von Istwert und Sollwert zur Korrektur des Tastverhältnisses oder der PWM-Frequenz in der folgenden Taktperiode herangezogen wird.

6. Verfahren nach Anspruch 5, **dadurch gekennzeichnet, daß** die Ermittlung der Differenz von Istwert und Sollwert zur Korrektur des Tastverhältnisses oder der PWM-Frequenz in jeder Taktperiode erfolgt.

7. Verfahren nach Anspruch 3, **dadurch gekennzeichnet, daß** die Steuersignale für die drei Umschalter (SW1, SW2, SW3) im Mikrocontroller (µC) erzeugt werden.

## Claims

1. Device for the rapid digital/analog (D/A) conversion of pulse width modulated (PWM) signals, particularly of digitized analog output signals from a lambda probe in a motor vehicle which have been converted into PWM signals, having an integrator (R1, C1, OP1), a changeover switch (SW3), a buffer amplifier (OP2) and a frequency divider (FF),
**characterized**
**in that** the integrator (OP1) is in the form of an inverting integrator and has a first operational amplifier (OP1) whose inverting input and whose output have a first capacitor (C1) arranged between them and whose noninverting input is supplied with a prescribed reference voltage (Uref),
**in that** a first changeover switch (SW1) is provided, which connects the inverting input of the operational amplifier (OP1)
- via its first and second connections (1x, 1y) and a resistor (R1) to the input of the device, and
- via its second and third connections (1y, 1z) to its output,
**in that** the integrator (OP1) has a second changeover switch (SW2) connected downstream which connects the integrator (OP1)
- via its first and third connections (2x, 2z) to a second capacitor (C2), and
- via its first and second connections (2x, 2y) to a third capacitor (C3),
**in that** the third changeover switch (SW3) connects the noninverting input of the second operational amplifier (OP2), which is connected as a buffer amplifier,
- via its second and third connections (3y, 3z) to the second capacitor (C2), and
- via its first and third connections (3x, 3z) to the third capacitor (C3),
**in that** the output of the second operational amplifier (OP2) is the output of the device,
**in that** a monostable multivibrator (MF) which is triggered by the input signal of the device and has a prescribed operating period is provided, whose output signal switches the first changeover switch (SW1), and
**in that** the output signal from the flip-flop (FF) triggered by the input signal of the device switches the second and third changeover switches (S2, SW3).

2. Device according to Claim 1, **characterized in that** a microcontroller (µC) is provided in which A/D conversion of analog signals into digital PWM signals takes place at a constant clock frequency.

3. Method for operating the device according to Claim 1, **characterized**
**in that**, at each rising edge (to, t3, t6) of the PWM signal, the monostable multivibrator (MF) is triggered for a prescribed operating period (to-tl, t3-t4, t6-t7) and, during this operating period, changes the first changeover switch (SW1) from its first position (1x, 1y), in which the PWM signal is supplied to the integrator (OP1, R1, C1), to its second position (1y, 1z), in which the first capacitor (C1) is shorted,
**in that** the PWM signal is integrated in the integrator (OP1, R1, C1) to form an integrator voltage which takes a prescribed reference voltage (Uref) as reference, and
**in that**, at each rising edge (to, t3, t6) of the PWM signal, the flip-flop (FF) is triggered, the output signals thereof changing over the second and third changeover switches (SW2, SW3) simultaneously,
- in one clock period, the second capacitor (C2) being charged to the integrator voltage, while the third capacitor (C3) is connected via the second operational amplifier (OP2) to the output of the device, at which the output signal from the preceding clock period can be tapped off, and
- in the following clock period, the third capacitor (C3) is charged to the integrator voltage, while the second capacitor (C2) is connected via the second operational amplifier (OP2) to the output of the device, at which the output signal from the one clock period can be tapped off.

4. Method according to Claim 3, **characterized in that** each High phase of the PWM signal is extended by the operating period of the monostable multivibrator (MF).

5. Method according to Claim 3 or 4, **characterized in that** the output signal from the device is supplied at particular times or at prescribed intervals to the microcontroller (µC), which converts it back into a digital value and compares it as an actual value with the digital value of the nominal value which is proportional to the pulse duty factor of the associated PWM signal, and
**in that** an ascertained difference between the actual value and the nominal value is used to correct the pulse duty factor or the PWM frequency in the following clock period.

6. Method according to Claim 5, **characterized in that** the difference between the actual value and the nominal value to correct the pulse duty factor or the PWM frequency is ascertained in each clock period.

7. Method according to Claim 3, **characterized in that** the control signals for the three changeover switches (SW1, SW2, SW3) are produced in the microcontroller (µC).

## Revendications

1. Dispositif destiné à la conversion rapide numérique-analogique (N/A) de signaux à modulation d'impulsions en durée (signaux MID), notamment de signaux, analogiques, numérisés et convertis en signaux MID, provenant d'une sonde lambda dans un véhicule automobile, comportant un circuit intégrateur (R1, C1, OP1), un inverseur (SW3), un amplificateur tampon (OP2) et un diviseur de fréquence (FF),
**caractérisé par le fait**
**que** le circuit intégrateur (OP1) est conçu comme circuit intégrateur inverseur et comporte un premier amplificateur opérationnel (OP1), un premier condensateur (C1) étant monté entre son entrée inverseuse et sa sortie et une tension de référence (Uref) prédéterminée étant appliquée à son entrée non inverseuse,
**qu'**il est prévu un premier inverseur (SW1) qui relie l'entrée inverseuse de l'amplificateur opérationnel (OP1),
- par l'intermédiaire de sa première et de sa deuxième borne (1x, 1y) et d'une résistance (R1), à l'entrée du dispositif et
- par l'intermédiaire de sa deuxième et de sa troisième borne (1y, 1z), à sa sortie,
**qu'**en aval du circuit intégrateur (OP1) est monté un deuxième inverseur (SW2) qui relie le circuit intégrateur (OP1),
- par l'intermédiaire de sa première et de sa troisième borne (2x, 2z), à un deuxième condensateur (C2) et
- par l'intermédiaire de sa première et de sa deuxième borne (2x, 2y) à un troisième condensateur (C3),
**que** le troisième inverseur (SW3) relie l'entrée non inverseuse du deuxième amplificateur opérationnel (OP2) connecté comme amplificateur tampon,
- par l'intermédiaire de sa deuxième et de sa troisième borne (3y, 3z), au deuxième condensateur (C2) et
- par l'intermédiaire de sa première et de sa troisième borne (3x, 3z) au troisième condensateur (C3),
**que** la sortie du deuxième amplificateur opérationnel (OP2) est la sortie du dispositif,
**qu'**il est prévu une bascule monostable (MF) pilotée par le signal d'entrée du dispositif et ayant un temps de repos prédéterminé et dont le signal de sortie commute le premier inverseur (SW1) et
**que** le deuxième et le troisième inverseur (SW2, SW3) sont commutés par le signal de sortie de la bascule bistable (FF) pilotée par le signal d'entrée du dispositif.

2. Dispositif selon la revendication 1 **caractérisé par le fait qu'**il est prévu un microcontrôleur (µC) dans lequel se produit une conversion A/N de signaux analogiques en signaux numériques MID avec une fréquence d'horloge constante.

3. Procédé destiné à exploiter le dispositif selon la revendication 1
**caractérisé par le fait**
**que**, sur chaque flanc positif (t0, t3, t6) du signal MID, la bascule monostable (MF) est pilotée pour une durée de repos prédéterminée (t0 - t1, t3 - t4, t6 - t7) et commute, pendant cette durée de repos, le premier inverseur (SW1) de sa première position (1x, 1y), dans laquelle le signal MID est appliqué au circuit intégrateur (OP1, R1, C1), vers sa deuxième position (1y, 1z), dans laquelle le premier condensateur (C1) est court-circuité,
**que** le signal MID subit une intégration dans le circuit intégrateur (OP1, R1, C1) pour donner une tension intégrée relative à une tension de référence (Uref) prédéterminée et
**que**, sur chaque flanc positif (t0, t3, t6) du signal MID, la bascule bistable (FF) est basculée et ses signaux de sortie commutent simultanément le deuxième et le troisième inverseur (SW2, SW3),
- le deuxième condensateur (C2) étant chargé, pendant l'une des périodes de la cadence, jusqu'à la tension de l'intégrateur, alors que le troisième condensateur (C3) est relié, à travers le deuxième amplificateur opérationnel (OP2), à la sortie du dispositif sur laquelle on peut prélever le signal de sortie de la période précédente de la cadence, et
- le troisième condensateur (C3) étant chargé, pendant la période suivante de la cadence, jusqu'à la tension de l'intégrateur, alors que le deuxième condensateur (C2) est relié, à travers le deuxième amplificateur opérationnel (OP2), à la sortie du dispositif sur laquelle on peut prélever le signal de sortie de l'une des périodes de la cadence.

4. Procédé selon la revendication 3 **caractérisé par le fait que** chaque phase High du signal MID est prolongée du temps de repos de la bascule monostable (MF).

5. Procédé selon la revendication 3 ou 4 **caractérisé par le fait que** le signal de sortie du dispositif est appliqué, à des instants définis ou à des intervalles de temps prédéterminés, au microcontrôleur (µC), qui le reconvertit en une valeur numérique et le compare en tant que valeur effective à la valeur de consigne proportionnelle à la valeur numérique du signal MID correspondant au taux d'impulsions et
qu'une différence déterminée entre la valeur effective et la valeur de consigne est utilisée, pendant la période suivante de la cadence, pour corriger le taux d'impulsions ou la fréquence MID.

6. Procédé selon la revendication 5 **caractérisé par le fait que** la détermination de la différence entre la valeur effective et la valeur de consigne pour la correction du taux d'impulsions ou de la fréquence MID est effectuée pendant chaque période de la cadence.

7. Procédé selon la revendication 3 **caractérisé par le fait que** les signaux de commande pour les trois inverseurs (SW1, SW2, SW3) sont générés dans le microcontrôleur (µC).
